# EUROPÄISCHE PATENTSCHRIFT

(11) **EP 3 807 661 B1**
(45) Veröffentlichungstag und Bekanntmachung des Hinweises auf die Patenterteilung: **02.07.2025**
(21) Anmeldenummer: 19727636.3
(22) Anmeldetag: 27.05.2019
(51) Int. Cl.: G01R 31/327

(54) **SCHALTÜBERWACHUNGSVORRICHTUNG**
SWITCHING MONITORING DEVICE
DISPOSITIF DE SURVEILLANCE DE COMMUTATION

(30) Priorität: 15.06.2018 DE 102018114425
(43) Veröffentlichungstag der Anmeldung: 21.04.2021
(73) Patentinhaber: Phoenix Contact GmbH & Co. KG, 32825 Blomberg (DE)
(72) Erfinder: SCHOLZ, Peter, 33034 Brakel (DE); SCHAPER, Elmar, 32676 Lügde (DE)
(74) Vertreter: Patentship Patentanwaltsgesellschaft mbH
(86) Internationale Anmeldenummer: PCT/EP2019/063672
(87) Internationale Veröffentlichungsnummer: WO 2019/238403

(56) Entgegenhaltungen:
- EP-A1- 2 662 697
- WO-A1-03/030198
- DE-A1- 102009 006 970
- DE-A1- 102010 011 394
- DE-A1- 102013 106 487
- DE-A1- 102014 016 218
- DE-U1- 202017 002 030
- GB-A- 2 090 002
- US-A1- 2007 115 604

## Beschreibung

Die vorliegende Offenbarung betrifft eine Schaltüberwachungsvorrichtung zur Überwachung eines Schaltvorgangs eines Relaisschaltkontakts.

In der elektrischen Automation können Aktoren jeweils mit einem Relais geschaltet werden. Es kann notwendig sein, dass ein tatsächliches Durchschalten eines Relaisschaltkontakts erfasst wird. Üblicherweise wird eine solche überwachte Rückmeldung über die Schaltung des Relais mittels zusätzlicher Hilfskontakte realisiert. Alternativ kann zum Unterbinden einer Fehlschaltung des Relais eine Kontaktzwangsführung realisiert sein. Mit der Kontaktzwangsführung kann bei einem fehlerhaften Relaisschaltkontakt, welcher beispielsweise defekte, insbesondere verschweißte Schaltflächen aufweist, ein Schalten weiterer Relaisschaltkontakte und/oder eine Verbindung der verschweißten Schaltflächen zu einer weiteren Schaltfläche unterbunden sein. Eine Kontaktzwangsführung und/oder eine Rückmeldung mittels Hilfskontakten können in nachteiliger Weise einen erhöhten Produktionsaufwand bei der Herstellung eines Relais aufweisen.

Die Druckschrift DE 10 2009 006970 A1 offenbart eine Prüfschaltung zur Funktionsprüfung für ein Bauelement, welche einen Transformator, eine Einspeiseschaltung zur Erzeugung einer Wechselspannung mit einer festlegbaren Frequenz, eine Messschaltung zur Ermittlung der Impedanz der Prüfschaltung und des Bauelements bei der festlegbaren Frequenz aufweist.

Die Druckschrift US 2007 / 115604 A1 offenbart ein System zum Überwachen eines elektrischen Relais. Das System umfasst ein elektrisches Relais; einen Widerstand, der permanent parallel zu dem Relais geschaltet ist und eine steuerbare elektrische Lasteinrichtung.

Die Druckschrift DE 10 2014 016218 A1 offenbart ein System zum Überwachen eines Relaiskontakts. Das System umfasst einen Emitter, der ausgebildet ist, ein Signal zu emittieren, und einen Empfänger, der ausgebildet ist, ein durch den Emitter emittiertes Signal zu erfassen.

Die Druckschrift DE 20 2017 002030 U1 offenbart eine Schaltung zur Funktionsprüfung eines elektrischen Relais, welche mechanische Defekte des Relais erkennt und signalisiert.

Die Druckschrift WO 03/030198 A1 offenbart eine Sicherheitsschaltvorrichtung zum sicheren Abschalten einer elektrischen Maschine.

Die Druckschrift EP 2 662 697 A1 offenbart eine Messvorrichtung zum Überprüfen eines elektrischen Leistungsschalters.

Die Druckschrift DE 10 2013 106487 A1 beschreibt eine Überwachungsschaltung zum Erkennen eines Schaltzustandes eines elektrischen Schaltkontaktes.

Es ist die Aufgabe der vorliegenden Offenbarung, eine effizientere Schaltüberwachungsvorrichtung bereitzustellen, welche eine Information über den Schaltzustand eines Relaisschaltkontaktes, insbesondere in Abhängigkeit von der Relaisansteuerung bereitstellt.

Diese Aufgabe wird durch die Merkmale des unabhängigen Anspruchs gelöst. Vorteilhafte Ausführungsformen sind Gegenstand der abhängigen Ansprüche, der Beschreibung sowie der beiliegenden Figuren.

Die vorliegende Offenbarung basiert auf der Erkenntnis, dass die obige Aufgabe durch eine Schaltüberwachungsvorrichtung gelöst werden kann, welche ausgebildet ist, den Relaisschaltkontakt mittels eines Signalgenerators und eines dem Signalgenerator nachgeschalteten Übertragers mit einem Schaltüberwachungssignal, insbesondere in Form einer hochfrequenten Hilfsenergie zu beaufschlagen. Das Schaltüberwachungssignal wird von dem Signalgenerator erzeugt und durch den Übertrager in den Lastschaltkreis des Relais eingekoppelt. Eine Änderung der Impedanz des Lastschaltkreises, insbesondere durch ein Schalten des Relaisschaltkontakts wird über den Übertrager zu dem Signalgenerator rückgekoppelt und erzeugt eine Signaländerung zwischen dem Signalgenerator und dem Übertrager, welche genutzt werden kann, um ein Schalten des Relaisschaltkontakts zu erfassen.

Gemäß einem ersten Aspekt betrifft die Offenbarung eine Schaltüberwachungsvorrichtung zur Überwachung eines Schaltvorgangs eines Relaisschaltkontakts eines Relais. Die Schaltüberwachungsvorrichtung weist eine Steuerung, welche ausgebildet ist ein Anregungssignal zu erzeugen und einen Ansteueranschluss auf, welcher ausgebildet ist, ein Ansteuersignal zum Schalten des Relaisschaltkontakts an den Relaisschaltkontakt anzulegen.

Ferner umfasst die Schaltüberwachungsvorrichtung eine Impedanzschaltung mit einem Signaleingang und einem Signalausgang, wobei die Steuerung ausgebildet ist, das Anregungssignal an den Signaleingang anzulegen. Die Impedanzschaltung ist ausgebildet, das Anregungssignal in ein Schaltüberwachungssignal zu überführen und das Schaltüberwachungssignal an dem Signalausgang zum Beaufschlagen des Relaisschaltkontaktes auszugeben.

Die Steuerung ist ferner ausgebildet, eine Änderung eines an der Impedanzschaltung anliegenden Signals zu überwachen und bei Vorliegen der Änderung des Signals einen Schaltvorgang des Relaisschaltkontakts festzustellen.

In einer Ausführungsform umfasst das Signal das Anregungssignal und/oder das Schaltüberwachungssignal.

Die Steuerung ist ausgebildet, eine Änderung des an der Impedanzschaltung anliegenden Anregungssignals zu überwachen und bei Vorliegen der Änderung des Anregungssignals einen Schaltvorgang des Relaisschaltkontakts festzustellen. Insbesondere kann die Steuerung ausgebildet sein, an Stelle eines Erfassens der Änderung des Schaltüberwachungssignals eine Änderung des Anregungssignals zu erfassen. Die Steuerung kann insbesondere neben der Impedanzschaltung eine weitere Signalüberwachungsschaltung zur Erfassung einer Änderung des Schaltüberwachungssignals aufweisen. Diese Signalüberwachungsschaltung kann ausgebildet sein, eine Änderung des Schaltüberwachungssignals mittels kapazitiver oder induktiver Kopplung zu erfassen.

Mit dem Überwachen des Relaisschaltkontakts durch die Schaltüberwachungsvorrichtung kann bei einem Beaufschlagen des Relais mit dem Ansteuersignal eine Schaltinformation bezüglich des Übergangs des Relaisschaltkontakts zwischen einem ersten Schaltzustand, in welchem der Relaisschaltkontakt elektrisch nichtleitend ist und einem zweiten Schaltzustand, in welchem der Relaisschaltkontakt elektrisch leitend ist, generiert werden. Dadurch kann sichergestellt sein, dass das Relais mit dem Ansteuersignal schaltet und entsprechend ein Fehler an dem Relaisschaltkontakt und/oder einem Magnetsystem des Relais nicht vorliegt. Entsprechend kann bei einem Anliegen des Ansteuersignals an dem Relais und einem Ausbleiben eines Schaltens des Relaisschaltkontakts eine Fehlfunktion des Relais festgestellt werden. Ferner kann auch ein Abschalten des Relais mit einem Abfallen des Schaltsignals überwacht werden.

Die Schaltüberwachungsvorrichtung erreicht den Vorteil, dass unter dem Aspekt der funktionalen Sicherheit, insbesondere nach der Norm IEC 61508 ein eindeutiges Erfassen des Schaltzustands des Relaisschaltkontakts realisiert werden kann. Entsprechend kann ein erhöhter Diagnosedeckungsgrad erreicht werden.

In einer Ausführungsform ist das Relais vorgesehen, Signale in einem ersten Frequenzbereich zu übertragen und das Schaltüberwachungssignal liegt in einem zweiten Frequenzbereich, wobei der zweite Frequenzbereich höhere Frequenzen als der erste Frequenzbereich aufweist, und wobei die Impedanzschaltung in dem ersten Frequenzbereich eine höhere Impedanz als in dem zweiten Frequenzbereich aufweist.

Die Impedanzschaltung kann einen Frequenzfilter, insbesondere einen Bandpassfilter bilden, welcher für das Schaltüberwachungssignal und/oder das Anregungssignal eine niedrigere Impedanz als für elektrische Signale mit anderen Frequenzen aufweist. Demnach kann ein Einkoppeln von elektrischen Signalen einer Spannungsquelle und/oder einer weiteren Signalquelle mit einer entsprechenden Leistungsübertragung unterbunden und/oder gedämpft sein. Beispielsweise kann der erste Frequenzbereich Frequenzen von 0 Hz bis 100 Hz umfassen und/oder der zweite Frequenzbereich kann Frequenzen oberhalb von 10 kHz, insbesondere den Frequenzbereich von 100 kHz bis 500 kHz umfassen. Mit der höheren Impedanz in dem ersten Frequenzbereich kann insbesondere ein ausgangsseitiger Stromfluss reduziert sein. Entsprechend kann durch die Kopplung des Signaleingangs mit dem Signalausgang in dem ersten Frequenzbereich ein eingangsseitiger Stromfluss reduziert sein.

Die Impedanzschaltung kann insbesondere ein Zweitor aufweisen, welches durch eine 2x2 Impedanzmatrix gebildet ist. Die Impedanz an dem Signalausgang kann für niedrige Frequenzen, beispielsweise in dem Frequenzbereich von 10 Hz bis 100 Hz, insbesondere 50 Hz, höher sein als für hohe Frequenzen, beispielsweise in dem Frequenzbereich von 100 kHz bis 1 MHz, insbesondere 500 kHz. Beispielsweise kann die Impedanz bei einer Frequenz von 50 Hz 13 MOhm betragen und bei einer Frequenz von 500 kHz 3 kOhm betragen. Entsprechend kann eine frequenzabhängige Impedanzdifferenz zwischen dem ersten Frequenzbereich und dem zweiten Frequenzbereich von drei bis vier Größenordnungen erreicht werden.

In einer Ausführungsform ist die Steuerung ausgebildet, das Anregungssignal in dem zweiten Frequenzbereich zu erzeugen. Dadurch wird der Vorteil erreicht, dass die Impedanzschaltung aufgrund der niedrigeren Impedanz in dem zweiten Frequenzbereich das Anregungssignal effizient in das Schaltüberwachungssignal wandeln kann.

In einer Ausführungsform weist die Steuerung eine Messschaltung zum Erfassen der Änderung des Anregungssignals auf. Die Messschaltung kann insbesondere ausgebildet sein, eine Amplitudenänderung des Anregungssignals, beispielsweise eine Spannungsamplitudenänderung und/oder eine Stromamplitudenänderung zu erfassen. Ferner kann die Messschaltung ausgebildet sein, eine Frequenzabweichung der Frequenz des Anregungssignals zu erfassen. Des Weiteren kann die Messschaltung einen Analog-Digital-Wandler und/oder einen Messsignalverstärker aufweisen, um das Messsignal, insbesondere eine Strom- und/oder Spannungsänderung des Anregungssignals weiterzuverarbeiten.

Die Steuerung weist einen Signalgenerator zum Erzeugen des Anregungssignals auf. Der Signalgenerator kann insbesondere ausgebildet sein, das Anregungssignal in Form eines periodischen Spannungssignals zu erzeugen. Beispielsweise kann das Anregungssignal eine rechteckförmige, sägezahnförmige oder sinusförmige Signalform aufweisen. Die Frequenz des Anregungssignals kann mittels des Signalgenerators auf einen vorbestimmten Wert einstellbar sein. Ferner kann der Signalgenerator ausgebildet sein das Anregungssignal mit einem festen Frequenzwert zu erzeugen.

In einer Ausführungsform weist die Messschaltung einen Stromsensor auf, welcher zwischen den Signalgenerator und die Impedanzschaltung geschaltet ist, wobei der Stromsensor ausgebildet ist, einen Stromfluss zwischen dem Signalgenerator und der Impedanzschaltung zu erfassen und der Steuerung als einen Strommesswert bereitzustellen, und wobei die Steuerung ausgebildet ist, auf Basis des Strommesswertes eine Änderung des Stromflusses zwischen dem Signalgenerator und der Impedanzschaltung zu erfassen.

Der Stromsensor kann durch einen, insbesondere ohmschen Widerstand gebildet sein, an welchem ein Stromfluss zwischen dem Signalgenerator und der Impedanzschaltung in Form einer Messspannung abgegriffen werden kann. Die Steuerung kann ferner ein Spannungsmessgerät umfassen, welches ausgebildet ist, die Messspannung zu erfassen.

Ferner kann die Steuerung einen Spannungssensor umfassen, welcher ausgebildet ist, eine Änderung einer Spannungsamplitude des Anregungssignals zu erfassen, um ein Schalten des Relaisschaltkontakts zu detektieren.

In einer Ausführungsform ist die Impedanzschaltung ausgebildet, den Relaisschaltkontakt von dem Signalgenerator und/oder der Steuerung galvanisch zu trennen. Der Relaisschaltkontakt kann mit einer elektrischen Leistung beaufschlagt sein, wobei ein Einkoppeln dieser elektrischen Leistung mittels der galvanischen Trennung in der Impedanzschaltung in die Steuerung und/oder den Signalgenerator unterbunden sein kann. Diese elektrische Leistung kann insbesondere größer sein als eine Leistung, mit welcher der Signalgenerator die Impedanzschaltung beaufschlagt.

Die Impedanzschaltung umfasst einen Transformator mit einer primärseitigen Spule und einer sekundärseitigen Spule, wobei die sekundärseitige Spule parallel zu dem Relaisschaltkontakt geschaltet ist, und wobei die primärseitige Spule mit dem Signalgenerator verbunden ist.

Der Transformator kann insbesondere ausgebildet sein, das Anregungssignal in das Schaltüberwachungssignal zu wandeln, wobei eine Stromamplitude und/oder eine Spannungsamplitude des Schaltüberwachungssignals in Abhängigkeit des Wicklungsverhältnisses der primärseitigen Spule zu der sekundärseitigen Spule proportional zu einer Stromamplitude und/oder einer Spannungsamplitude des Anregungssignals sind. Die primärseitige Spule und die sekundärseitige Spule können elektromagnetisch gekoppelt sein, sodass Änderungen des Schaltüberwachungssignals mittels des Transformators eingangsseitig auf das Anregungssignal wirken können.

Falls sich der Relaisschaltkontakt in dem ersten Schaltzustand befindet, kann für das Schaltüberwachungssignal ein niederimpedanter Anschluss nicht vorhanden sein, sodass durch die sekundärseitige Spule ein Strom mit einer geringeren Stromstärke als in dem zweiten Schaltzustand fließen kann.

Der parallel zu dem Relaisschaltkontakt angeordnete Kondensator kann mit der sekundärseitigen Spule einen Schwingkreis mit einer vorbestimmten Resonanzfrequenz bilden. Dieser Schwingkreis kann mit dem Relaisschaltkontakt in dem zweiten Schaltzustand eine geringere Dämpfung aufweisen als mit dem Relaisschaltkontakt in dem ersten Schaltzustand. Entsprechend kann bei einer Anregung des Schwingkreises durch den Signalgenerator eine Schwingungsamplitude des Schwingkreises mit dem Relaisschaltkontakt in dem zweiten Schaltzustand höher sein als eine Schwingungsamplitude des Schwingkreises mit dem Relaisschaltkontakt in dem ersten Schaltzustand. Die Steuerung kann ausgebildet sein, diese Amplitudenänderung der Schwingung mittels eines zwischen dem Signalgenerator und dem Signaleingang angeordneten Widerstands zu erfassen.

In einer Ausführungsform kann an der primärseitigen Spule des Transformators eine zusätzliche elektromagnetische Spule angeordnet sein, welche ausgebildet ist, eine Änderung des Anregungssignals bei einer Änderung des Schaltüberwachungssignals durch Schalten des Relaisschaltkontakts zu erfassen. Die Steuerung kann ausgebildet sein, ein in der zusätzlichen elektromagnetischen Spule induziertes Signal auszuwerten, um ein Schalten des Relaisschaltkontaktes zu detektieren. Die zusätzliche elektromagnetische Spule kann neben der primärseitigen Spule auf einem ferromagnetischen Kern des Transformators angeordnet sein. In einer Ausführungsform kann die weitere elektromagnetische Spule die primärseitige Spule zumindest teilweise umschließen, insbesondere über die primärseitige Spule gewickelt sein.

Die Impedanzschaltung weist einen Kondensator auf, welcher in Reihe zu der sekundärseitigen Spule angeordnet ist, wobei der Kondensator ausgebildet ist, einen Blindwiderstand für Wechselspannungssignale zu bilden, welche an dem Relaisschaltkontakt anliegen.

Die Impedanzschaltung kann den Relaisschaltkontakt mit einem insbesondere periodischen Schaltüberwachungssignal beaufschlagen. In dem ersten Schaltzustand kann eine Impedanz an dem Signalausgang durch den Kondensator bestimmt sein. In dem zweiten Schaltzustand kann die Impedanz an dem Signalausgang niedriger sein als die Impedanz an dem Signalausgang, wenn der Relaisschaltkontakt sich in dem ersten Schaltzustand befindet. Mit einer niedrigeren Impedanz an dem Signalausgang kann eine Stromstärke des durch den Signalausgang der Impedanzschaltung fließenden Stroms größer sein, als bei einer höheren Impedanz an dem Signalausgang. Die Impedanzschaltung kann ausgebildet sein, eine entsprechende Stromstärkenänderung an den Signaleingang zu koppeln, sodass eine Stromstärke eines durch den Signaleingang fließenden Stroms bei einer verringerten ausgangsseitigen Impedanz ansteigt.

Ferner kann sich bei einem Schalten des Relaisschaltkontakts eine Spannungsamplitude des Schaltüberwachungssignals ändern, wobei sich mit der Änderung der Spannungsamplitude des Schaltüberwachungssignals eine Strom- und/oder Spannungsamplitude des Anregungssignals ändern kann.

Der Kondensator kann ferner einen Blindwiderstand für Wechselspannungssignale bilden, welche von einer Spannungsquelle erzeugt werden und an dem Relaisschaltkontakt anliegen. Weiterhin kann der Kondensator ausgebildet sein, eine Verlustleistung an dem Signalausgang und/oder Leckströme zu reduzieren, welche mit dem Relaisschaltkontakts in den ersten Schaltzustand durch den Signalausgang fließen können.

Der Kondensator kann ausgebildet sein, einer Wechselspannung und/oder einer Gleichspannung von 230 V inklusive zu erwartender Transienten zerstörungsfrei standzuhalten.

In einer Ausführungsform kann der Kondensator durch einen Plattenkondensator in Form von Leitungsbahnen auf einer Leiterplatte gebildet sein. Die Eigenschaften des Kondensators können durch das Leiterplattenmaterial und/oder die Leiterplattendicke bestimmt sein, sodass eine definierte Spannungsfestigkeit durch einen Abstand zwischen zwei Leiterbahnenabschnitten und/oder Leiterflächen realisiert sein kann. Das Leiterplattenmaterial kann insbesondere FR4 sein, welches aus einem Glasfasergewebe, insbesondere mit einer Di/Tetra-Epoxy-Matrix gebildet ist.

In einer Ausführungsform sind der Signaleingang zweipolig mit einem ersten Eingangsanschluss und einem zweiten Eingangsanschluss und der Signalausgang zweipolig mit einem ersten Ausgangsanschluss und einem zweiten Ausgangsanschluss ausgebildet, und zwischen dem ersten Ausgangsanschluss und dem ersten Eingangsanschluss ist ein erster Kondensator und zwischen dem zweiten Ausgangsanschluss und dem zweiten Eingangsanschluss ist ein zweiter Kondensator angeordnet, um das Schaltüberwachungssignal kapazitiv an den Relaisschaltkontakt zu koppeln.

In einer Ausführungsform weist die Impedanzschaltung eine Induktivität auf, welche dem ersten Kondensator nachgeschaltet ist, wobei die Induktivität mit dem ersten Kondensator zwischen dem ersten Ausgangsanschluss und dem ersten Eingangsanschluss ein schwingfähiges System bildet.

In einer Ausführungsform umfasst die Schaltüberwachungsvorrichtung einen ersten Auskoppelungskondensator, einen zweiten Auskoppelungskondensator und eine Signalüberwachungsschaltung. Der erste Auskoppelungskondensator an den ersten Ausgangsanschluss und der zweite Auskoppelungskondensator an den zweiten Ausgangsanschluss anschließbar ist, und wobei die Auskoppelungskondensatoren an die Signalüberwachungsschaltung angeschaltet und ausgebildet sind, das Schaltüberwachungssignal in ein Prüfsignal zu überführen und das Prüfsignal der Signalüberwachungsschaltung bereitzustellen, und/oder wobei die Signalüberwachungsschaltung ausgebildet ist, eine Änderung des Prüfsignals zu überwachen und bei Vorliegen der Änderung des Prüfsignals einen Schaltvorgang des Relaisschaltkontakts festzustellen.

Ferner können der erste Auskoppelungskondensator, der zweite Auskoppelungskondensator und/oder die Signalüberwachungsschaltung in die Steuerung integriert sein. In einer Ausführungsform kann die Impedanzschaltung die Auskoppelungskondensatoren umfassen.

In einer Ausführungsform ist die Steuerung an den Ansteueranschluss anschließbar und ausgebildet ist, ein Ansteuersignal zum Schalten des Relaisschaltkontakts zu erzeugen und/oder den Ansteueranschluss mit dem Ansteuersignal zu beaufschlagen.

Die Induktivität kann insbesondere eine elektromagnetische Spule sein, welche eine elektrische Induktivität aufweist, welche auf die Kapazität des vorgeschalteten Kondensators derart abgestimmt ist, dass die kombinierte Impedanz der elektromagnetischen Spule und des Kondensators bei einer Resonanzfrequenz minimal ist.

Der Signalgenerator kann beispielsweise ausgebildet sein, das Anregungssignal mit der Resonanzfrequenz zu erzeugen.

In einer Ausführungsform weist die Impedanzschaltung eine weitere Induktivität auf, welche dem zweiten Ausgangsanschluss nachgeschaltet ist, wobei die weitere Induktivität mit dem zweiten Kondensator zwischen dem zweiten Ausgangsanschluss und dem zweiten Eingangsanschluss ein weiteres schwingfähiges System bildet.

In einer Ausführungsform ist die Impedanzschaltung ausgebildet, den Relaisschaltkontakt mit dem Schaltüberwachungssignal in Form einer hochfrequenten Hilfsenergie zu beaufschlagen, welche insbesondere eine Frequenz in dem Bereich von 10 KHz bis 1 MHz aufweist. Vorzugsweise erzeugt der Signalgenerator Das Anregungssignal mit einer Frequenz von 100 kHz bis 500 kHz, welches insbesondere ein rechteckförmiges Taktsignal sein kann. Die Frequenz des Anregungssignals kann fest und/oder durch die Steuerung vorbestimmt sein. Die Impedanzschaltung kann ausgebildet sein, das Anregungssignal mit einer Kopplungsfrequenz in das Schaltüberwachungssignal mit der Kopplungsfrequenz zu wandeln.

In einer Ausführungsform umfasst die Steuerung eine Schaltsteuerung, welche ausgebildet ist, das Ansteuersignal zum Schalten des Relaisschaltkontakts zu erzeugen und ein Magnetsystem des Relais mit Ansteuersignal zu beaufschlagen, um den Relaisschaltkontakt zu schalten.

Die Steuerung kann ferner ausgebildet sein, den Signalgenerator mit elektrischer Energie zu versorgen. Eine Ansteuerung des Relais kann mit einem Erzeugen des Anregungssignals durch den Signalgenerator gekoppelt sein, sodass beispielsweise gleichzeitig mit der Ansteuerung des Relais das Anregungssignal erzeugt und der Relaisschaltkontakt mit dem Schaltüberwachungssignal beaufschlagt werden kann.

In einer Ausführungsform ist die Steuerung ausgebildet, den Signalgenerator mit dem Ansteuersignal zu beaufschlagen, und der Signalgenerator ist ausgebildet, mit dem Schaltsignal das Anregungssignal zu erzeugen. Dadurch wird der Vorteil erreicht, dass der Signalgenerator mit dem gleichen elektrischen Signal gespeist werden kann, welches auch zum Ansteuern des Relais genutzt wird. Entsprechend kann eine separate Energieversorgung für den Signalgenerator und/oder die Steuerung entfallen.

In einer Ausführungsform kann die Steuerung ausgebildet sein, eine Stromstärke des Schaltsignals und/oder eine Stromstärke des durch eine Relaisspule des Magnetsystems fließenden Stroms, insbesondere mittels eines Shunt-Widerstands zu erfassen.

Der Relaisschaltkontakt kann eine typische Anschaltverzögerung von 1 ms bis 50 ms aufweisen, wobei mit einer gleichzeitigen Ansteuerung des Relais und des Signalgenerators mit dem Ansteuersignal, das Schaltüberwachungssignal an dem Relaisschaltkontakt anliegt, bevor der Relaisschaltkontakt entsprechend dem Ansteuersignal zwischen dem ersten Schaltzustand und dem zweiten Schaltzustand wechselt. Die Signalkette von dem Signalgenerator über die Impedanzschaltung zu dem Relaisschaltkontakt kann entsprechend eine geringere Signallaufzeit als die Anschaltverzögerung des Relais aufweisen.

Ferner kann der Signalgenerator ausgebildet sein, das Anregungssignal nach einem Abfallen des Ansteuersignals für ein Zeitintervall, welches insbesondere größer ist als eine typische Abschaltverzögerung des Relais, weiter zu erzeugen, um einen Wechsel des Relaisschaltkontakts von dem zweiten Schaltzustand in den ersten Schaltzustand zu erfassen.

Die Schaltüberwachungsvorrichtung kann ausgebildet sein, die Steuerung, den Signalgenerator, die Impedanzschaltung und/oder das Magnetsystem des Relais mit einem an der Steuerung anliegenden Relaisansteuersignal zur Steuerung des Relais zu beaufschlagen, um die jeweilige Komponente mit elektrischer Energie zu versorgen. Entsprechend kann eine separate Energiequelle und/oder Energieversorgung des Signalgenerators, der Impedanzschaltung und/oder der Steuerung entfallen, da diese direkt mit dem Relaisansteuersignal mit elektrischer Energie versorgt werden können.

In einer Ausführungsform ist der Signalgenerator ausgebildet, das Anregungssignal in Form eines periodischen Taktsignals zu generieren, und die Steuerung ist ausgebildet, auf Basis der konstanten Periodendauer des Anregungssignals ein Zeitintervall zwischen dem Erzeugen des Anregungssignals und einer Änderung des Anregungssignals bei Änderung der Impedanz an dem Signalausgang zu erfassen, um eine Schaltzeitverzögerung des Relaisschaltkontakts zu erfassen.

Die Steuerung kann insbesondere ausgebildet sein, eine Anzahl von Perioden und/oder Taktzyklen des Anregungssignals zu erfassen und entsprechend der festen Frequenz des Anregungssignals das Zeitintervall zwischen dem Erzeugen des Anregungssignals und einem Schalten des Relaisschaltkontakts zu erfassen. Mit dem Schalten des Relaisschaltkontakts kann sich eine ausgangsseitige Impedanz ändern, welche eine Anregungssignaländerung bewirkt. Die Anregungssignaländerung kann mittels eines Sensors von der Steuerung erfasst werden, um ein Schalten des Relaisschaltkontakts und ein Ende des Zeitintervalls zwischen Relaisansteuerung und Schalten des Relaisschaltkontakts zu bestimmen.

Die Steuerung kann ferner ausgebildet sein, den Signalgenerator anzusteuern, bevor der Relaisschaltkontakt schaltet. Entsprechend kann das Schaltüberwachungssignal während eines Einschaltvorgangs des Relaisschaltkontakts und/oder während eines Abschaltvorgangs des Relaisschaltkontakts an dem Relaisschaltkontakt anliegen. Vorteilhafterweise kann das Schaltüberwachungssignal abgeschaltet sein, während sich der Relaisschaltkontakt in dem ersten Schaltzustand oder dem zweiten Schaltzustand befindet. Insbesondere liegt das Schaltüberwachungssignal nur während einer Schaltzeit an, in welcher der Relaisschaltkontakt zwischen dem ersten Schaltzustand und dem zweiten Schaltzustand wechselt.

In einer Ausführungsform weist die Steuerung einen Steuerausgang auf, und die Steuerung ist ausgebildet, an dem Steuerausgang ein Statussignal bereitzustellen, welches nach einem Einschalten des Relaisschaltkontakts aktiv ist und nach einem Ausschalten des Relaisschaltkontakts inaktiv ist.

Dadurch wird der Vorteil erreicht, dass Statussignale einer Mehrzahl von Schaltüberwachungsvorrichtungen an einer zentralen Stelle aggregiert werden können, um das Schalten einer Mehrzahl von Relais zentral und insbesondere entfernt von dem Einbauort des jeweiligen Relais der Mehrzahl von Relais überwachen zu können.

Der Steuerausgang kann ferner ein Fehlermeldekontakt und/oder ein Abbild des Relaisschaltkontaktes sein. Ferner kann der Steuerausgang eine analoge und/oder digitale Schnittstelle umfassen, welche ausgebildet ist, Informationen über das Relais und den Schaltzustand des Relais zu übertragen.

In einer Ausführungsform umfasst die Schaltüberwachungsvorrichtung ein erstes Dämpfungselement und der Signalausgang weist einen ersten Ausgangsanschluss auf, welchem das erste Dämpfungselement nachgeschaltet ist, um hochfrequente Signale, welche mittels der Impedanzschaltung an den Relaisschaltkontakt und/oder eine an den Relaisschaltkontakt gekoppelte elektrische Last und/oder Spannungsquelle anliegen, zu dämpfen.

Dadurch wird der Vorteil erreicht, dass die Eigenschaften der Schaltüberwachungsvorrichtung in Bezug auf eine elektromagnetische Verträglichkeit verbessert werden können. Die Dämpfungselemente können insbesondere ausgebildet sein, eine Signalamplitude des Schaltüberwachungssignals zu dämpfen, um eine elektromagnetische Abstrahlung des Schaltüberwachungssignals in die Umgebung der Schaltüberwachungsvorrichtung und/oder des Relais zu verringern.

In einer Ausführungsform umfasst die Schaltüberwachungsvorrichtung ein zweites Dämpfungselement und der Signalausgang weist einen zweiten Ausgangsanschluss auf, welchem das zweite Dämpfungselement nachgeschaltet ist, um hochfrequente Signale, welche mittels der Impedanzschaltung an dem Relaisschaltkontakt und/oder an einer an den Relaisschaltkontakt gekoppelten elektrische Last und/oder Spannungsquelle anliegen, zu dämpfen.

In einer Ausführungsform weist das erste Dämpfungselement und/oder das zweite Dämpfungselement jeweils eine Induktivität auf, und wobei die jeweilige Induktivität eine Mindestimpedanz für das Schaltüberwachungssignal bildet, um einen Bypass des Schaltüberwachungssignals über die elektrische Last und/oder die Spannungsquelle zu unterbinden.

Dadurch wird der Vorteil erreicht, dass ein Schalten des Relaisschaltkontakts zwischen dem ersten Schaltzustand und dem zweiten Schaltzustand auch bei einer niederimpedanten Stromquelle und/oder einer niederimpedanten elektrischen Last zuverlässig erfasst werden kann. Falls ein Strompfad durch die Stromquelle und die elektrische Last eine kleinere Impedanz aufweist als beispielsweise der parallel zu dem Relaisschaltkontakt geschaltete Kondensator, kann das Schaltüberwachungssignal über die Stromquelle und/oder die elektrische Last fließen, sodass ein Schalten des Relaisschaltkontakts eine an dem Signalausgang registrierte Impedanz nicht oder nur in reduziertem Maße beeinflusst.

Vorteilhafterweise sind die Induktivitäten niederohmig ausgebildet, um Leistungsverluste bei einem Stromfluss durch die Induktivitäten zu minimieren. In einer Ausführungsform sind die Induktivitäten ausgebildet von einem Gesamtlaststrom durchflossen zu werden, welcher durch den Relaisschaltkontakt fließt und durch eine Leistung einer Spannungsquelle und einer Impedanz einer an den Relaisschaltkontakt geschalteten Last bestimmt ist. Die Induktivitäten können gemeinsam auf einem Spulenkern, insbesondere einem Magnetkern angeordnet sein und insbesondere eine stromkompensierte Drossel bilden. Die Induktivitäten können ferner mit zueinander entgegen gerichteten Wicklungsrichtungen ineinander verschachtelt sein, um eine möglichst hohe Gegentaktimpedanz für das Schaltüberwachungssignal zu bilden.

Weitere Ausführungsbeispiele werden Bezug nehmend auf die beiliegenden Figuren erläutert. Es zeigen:
- Fig. 1: eine Schaltüberwachungsvorrichtung in einer Ausführungsform;
- Fig. 2: eine Schaltüberwachungsvorrichtung in einer Ausführungsform;
- Fig. 3: eine Schaltüberwachungsvorrichtung in einer Ausführungsform;
- Fig. 4: Signalformen bei einer Ansteuerung eines Relais mittels der Schaltüberwachungsvorrichtung in einer Ausführungsform;
- Fig. 5: eine Ereignissequenz bei dem Einschalten eines Relais mittels der Schaltüberwachungsvorrichtung in einer Ausführungsform;
- Fig. 6: eine Ereignissequenz bei dem Ausschalten eines Relais mittels der Schaltüberwachungsvorrichtung in einer Ausführungsform; und
- Fig. 7: eine schematische Darstellung einer Schaltüberwachungsvorrichtung zur Überwachung eines Schaltvorgangs eines Relaisschaltkontakts eines Relais.

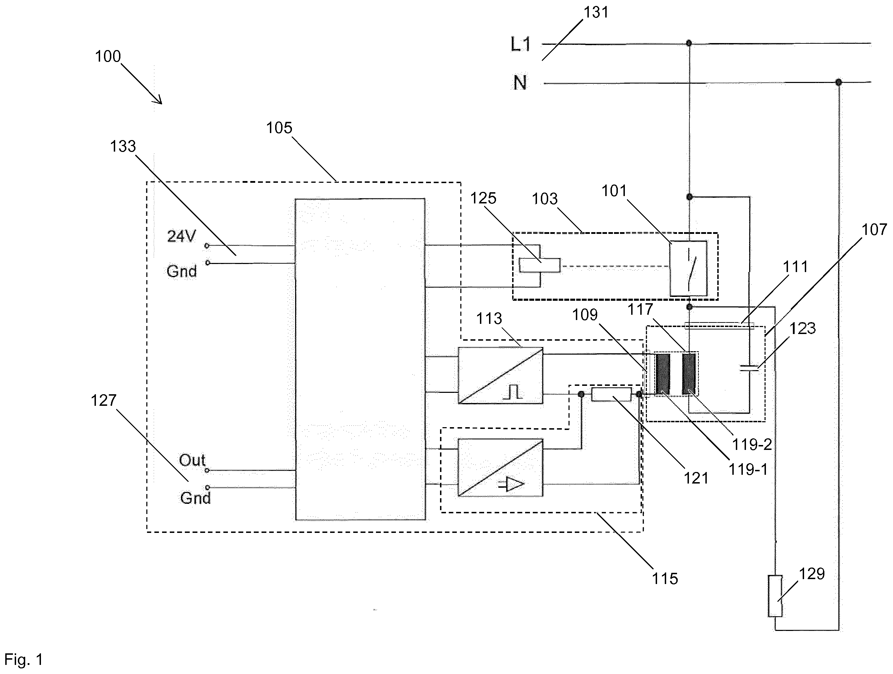

Fig. 1 zeigt eine schematische Darstellung einer Schaltüberwachungsvorrichtung 100 zur Überwachung eines Schaltvorgangs eines Relaisschaltkontakts 101 eines Relais 103. Die Schaltüberwachungsvorrichtung 100 weist eine Steuerung 105 auf, welche ausgebildet ist, ein Ansteuersignal zum Schalten des Relaisschaltkontakts 101 und ein Anregungssignal zu erzeugen.

Ferner umfasst die Schaltüberwachungsvorrichtung 100 eine Impedanzschaltung 107 mit einem Signaleingang 109 und einem Signalausgang 111. Die Steuerung 105 ist ausgebildet, das Anregungssignal an den Signaleingang 109 anzulegen. Die Impedanzschaltung 107 ist ausgebildet, das Anregungssignal in ein Schaltüberwachungssignal zu überführen und das Schaltüberwachungssignal an dem Signalausgang 111 zum Beaufschlagen des Relaisschaltkontaktes 101 auszugeben.

Weiterhin ist die Steuerung 105 ausgebildet, eine Änderung eines an der Impedanzschaltung 107 anliegenden Signals, insbesondere des Anregungssignals und/oder des Schaltüberwachungssignals, zu überwachen und bei Vorliegen der Signaländerung einen Schaltvorgang des Relaisschaltkontakts 101 festzustellen.

Das Relais 103 ist vorgesehen, Signale in einem ersten Frequenzbereich zu übertragen und das Schaltüberwachungssignal liegt in einem zweiten Frequenzbereich, wobei der zweite Frequenzbereich höhere Frequenzen als der erste Frequenzbereich aufweist. Ferner weist die Impedanzschaltung 107 in dem ersten Frequenzbereich eine höhere Impedanz als in dem zweiten Frequenzbereich auf.

Ferner umfasst die Steuerung 105 einen Signalgenerator 113, welcher ausgebildet ist, das Anregungssignal in dem zweiten Frequenzbereich zu erzeugen. Die Impedanzschaltung 107 ist ausgebildet, den Relaisschaltkontakt 101 von dem Signalgenerator 113 und/oder der Steuerung 105 galvanisch zu trennen.

Weiterhin umfasst die Steuerung 105 eine Messschaltung 115 zum Erfassen der Änderung des Anregungssignals. Die Messschaltung 115 weist einen Stromsensor 121 auf, welcher zwischen den Signalgenerator 113 und die Impedanzschaltung 107 geschaltet ist. Der Stromsensor 121 ist ausgebildet, einen Stromfluss zwischen dem Signalgenerator 113 und der Impedanzschaltung 107 zu erfassen und der Steuerung 105 als einen Strommesswert bereitzustellen. Weiterhin ist die Steuerung 105 ausgebildet, auf Basis des Strommesswertes eine Änderung des Stromflusses zwischen dem Signalgenerator 113 und der Impedanzschaltung 107 zu erfassen.

Die Impedanzschaltung 107 umfasst einen Transformator 117 mit einer primärseitigen Spule 119-1 und einer sekundärseitigen Spule 119-2, wobei die sekundärseitige Spule 119-2 parallel zu dem Relaisschaltkontakt 101 geschaltet ist, und die primärseitige Spule 119-1 mit dem Signalgenerator 113 verbunden ist. Weiterhin umfasst die Impedanzschaltung 107 einen Kondensator 123, welcher in Reihe zu der sekundärseitigen Spule 119-2 angeordnet ist. Der Kondensator 123 ist ausgebildet, einen Blindwiderstand für Wechselspannungssignale zu bilden, welche an dem Relaisschaltkontakt 101 anliegen.

Weiterhin ist die Impedanzschaltung 107 ausgebildet, den Relaisschaltkontakt 101 mit dem Schaltüberwachungssignal in Form einer hochfrequenten Hilfsenergie zu beaufschlagen, welche insbesondere eine Frequenz in dem Bereich von 10 KHz bis 1 MHz aufweist.

Ferner umfasst die Steuerung 105 eine Schaltsteuerung, welche ausgebildet ist, das Ansteuersignal zum Schalten des Relaisschaltkontakts 101 zu erzeugen und ein Magnetsystem 125 des Relais 103 mit dem Ansteuersignal zu beaufschlagen, um den Relaisschaltkontakt 101 zu schalten.

In einer Ausführungsform ist die Steuerung 105 ausgebildet, den Signalgenerator 113 mit dem Ansteuersignal zu beaufschlagen, und der Signalgenerator 113 ist ausgebildet, mit dem Schaltsignal das Anregungssignal zu erzeugen.

Ferner ist der Signalgenerator 113 ausgebildet, das Anregungssignal in Form eines periodischen Taktsignals zu generieren, und die Steuerung 105 ist ausgebildet, auf Basis der konstanten Periodendauer des Anregungssignals ein Zeitintervall zwischen dem Erzeugen des Anregungssignals und einer Änderung des Anregungssignals bei Änderung der Impedanz an dem Signalausgang 111 zu erfassen, um eine Schaltzeitverzögerung des Relaisschaltkontakts 101 zu erfassen.

Weiterhin umfasst die Steuerung 105 einen Steuerausgang 127 und die Steuerung 105 ist ausgebildet, an dem Steuerausgang 127 ein Statussignal bereitzustellen, welches nach einem Einschalten des Relaisschaltkontakts 101 aktiv ist und nach einem Ausschalten des Relaisschaltkontakts 101 inaktiv ist.

Die Steuerung 105 umfasst ferner einen Ansteuereingang 133, über welchen die Steuerung 105 mit elektrischer Energie versorgt werden kann. Insbesondere kann die Steuerung 105 ausgebildet sein, elektrische Energie in Form einer Gleichspannung in dem Bereich von 3 V bis 24 V aufzunehmen.

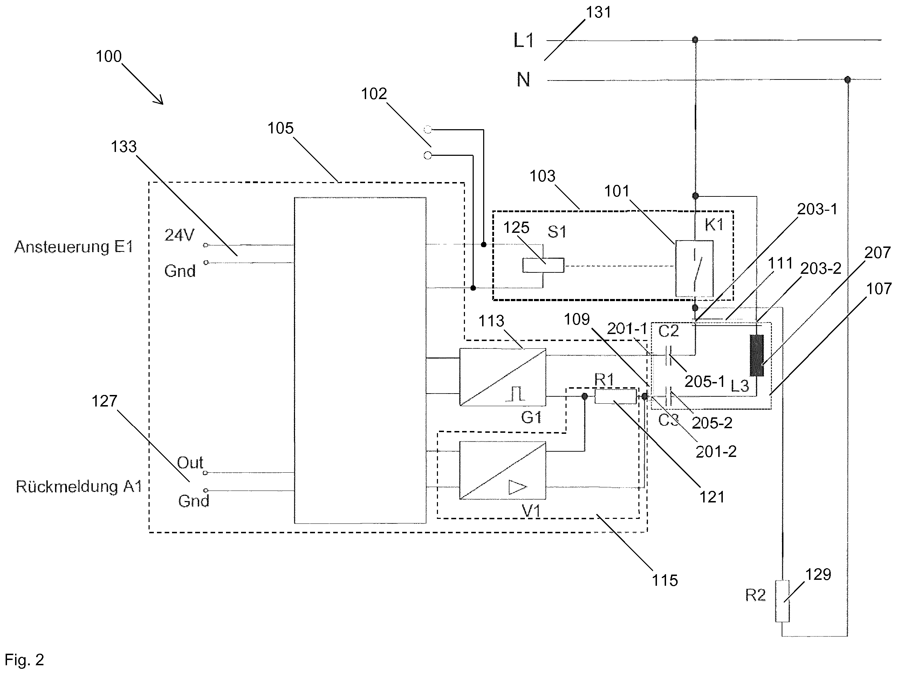

Fig. 2 zeigt eine schematische Darstellung einer Schaltüberwachungsvorrichtung 100 zur Überwachung eines Schaltvorgangs eines Relaisschaltkontakts 101 eines Relais 103 in einer Ausführungsform. Der Signaleingang 109 ist zweipolig mit einem ersten Eingangsanschluss 201-1 und einem zweiten Eingangsanschluss 201-2 und der Signalausgang 111 ist zweipolig mit einem ersten Ausgangsanschluss 203-1 und einem zweiten Ausgangsanschluss 203-2 ausgebildet. Ferner ist zwischen dem ersten Ausgangsanschluss 203-1 und dem ersten Eingangsanschluss 201-1 ein erster Kondensator 205-1 und zwischen dem zweiten Ausgangsanschluss 203-2 und dem zweiten Eingangsanschluss 201-2 ein zweiter Kondensator 205-2 angeordnet, um das Schaltüberwachungssignal kapazitiv an den Relaisschaltkontakt 101 zu koppeln.

Weiterhin umfasst die Impedanzschaltung 107 eine Induktivität 207, welche dem ersten Kondensator 205-1 nachgeschaltet ist, wobei die Induktivität 207 mit dem ersten Kondensator 205-1 zwischen dem ersten Ausgangsanschluss 203-1 und dem ersten Eingangsanschluss 201-1 ein schwingfähiges System bildet.

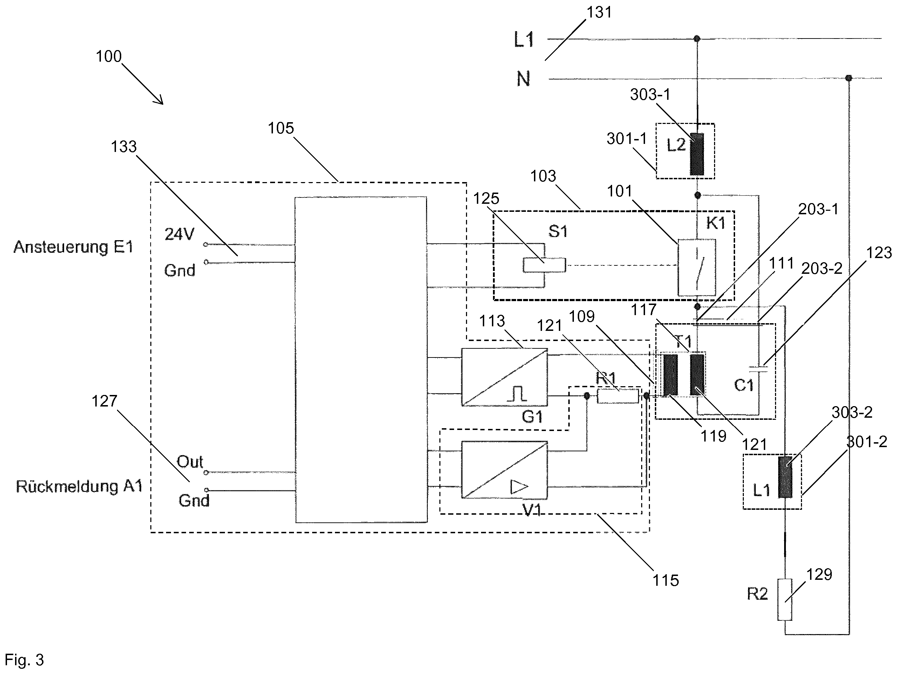

Fig. 3 zeigt eine schematische Darstellung einer Schaltüberwachungsvorrichtung 100 zur Überwachung eines Schaltvorgangs eines Relaisschaltkontakts 101 eines Relais 103 gemäß der in Fig. 1 gezeigten Ausführungsform.

Zusätzlich umfasst die Schaltüberwachungsvorrichtung 100 ein erstes Dämpfungselement 301-1 und ein zweites Dämpfungselement 301-2. Der Signalausgang 111 weist einen ersten Ausgangsanschluss 203-1 und einen zweiten Ausgangsanschluss 203-2 auf, wobei das erste Dämpfungselement 301-1 dem ersten Ausgangsanschluss 203-1 und das zweite Dämpfungselement 301-2 dem zweiten Ausgangsanschluss 203-2 nachgeschaltet ist, um hochfrequente Signale, welche mittels der Impedanzschaltung 107 an den Relaisschaltkontakt 101 und/oder eine an den Relaisschaltkontakt 101 gekoppelte elektrische Last 129 und/oder Spannungsquelle 131 anliegen, zu dämpfen.

Das erste Dämpfungselement 301-1 und das zweite Dämpfungselement 301-2 weisen jeweils eine Induktivität 303-1, 303-2 auf, welche eine Mindestimpedanz für das Schaltüberwachungssignal bilden, um einen Bypass des Schaltüberwachungssignals über die elektrische Last 129 und/oder die Spannungsquelle 131 zu unterbinden.

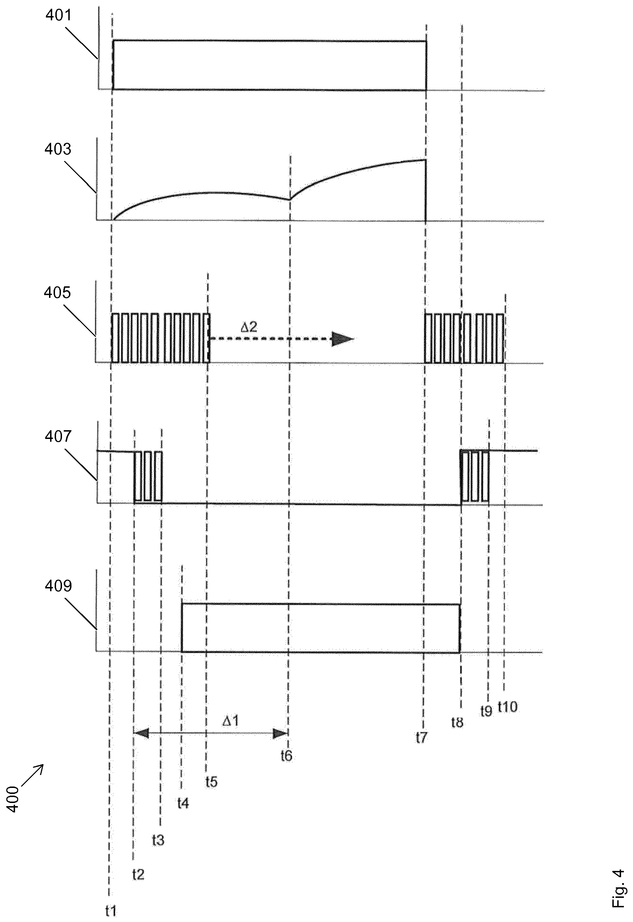

Fig. 4 zeigt eine schematische Darstellung von Signalformen 400 bei einer Ansteuerung eines Relais mittels der Schaltüberwachungsvorrichtung. Zu einem ersten Zeitpunkt t1 wird eine elektromagnetische Relaisspule des Magnetsystems des Relais mit einem Relaisansteuersignal beaufschlagt. Entsprechend liegt eine Spulenspannung 401 an der elektromagnetischen Relaisspule an. Mit dem Anliegen der Spulenspannung 401 an der elektromagnetischen Relaisspule steigt ein Spulenstrom 403 in der elektromagnetischen Relaisspule an.

Ferner erzeugt der Signalgenerator der Schaltüberwachungsvorrichtung ab dem Zeitpunkt t1 das Anregungssignal 405 in Form eines rechteckförmigen Signals, welches insbesondere eine ausschließlich positive Signalamplitude aufweist. Mittels der Impedanzschaltung wird das Anregungssignal 405 in das Schaltüberwachungssignal 407 gewandelt, mit welchem der Relaisschaltkontakt beaufschlagt ist. Das Schaltüberwachungssignal 407 weist ab dem Zeitpunkt t2 die Signalform des Anregungssignals 405 auf.

Bis zu dem Zeitpunkt t2 ist der Relaisschaltkontakt in dem ersten Schaltzustand und entsprechend elektrisch nicht leitend respektive hochohmig. Der Gesamtwiderstand welcher an dem zweipoligen Signalausgang der Impedanzschaltung erfassbar ist, kann durch die externe Beschaltung bestehend aus einer elektrischen Last und/oder einer Spannungsquelle bestimmt sein. Ferner können in einer Ausführungsform die Dämpfungselemente, insbesondere in Form von Induktivitäten zu dem Gesamtwiderstand beitragen. Entsprechend dem Gesamtwiderstand kann zwischen dem Signalgenerator und der Impedanzschaltung mittels des Stromsensors ein Stromfluss erfasst werden.

Ab dem Zeitpunkt t2 schaltet der Relaisschaltkontakt von dem ersten Schaltzustand in den zweiten Schaltzustand, wobei das Zeitintervall zwischen t2 und t3 eine Prelldauer des Relaisschaltkontakts bestimmt. Mit dem Schalten des Relaisschaltkontakts bricht das Schaltüberwachungssignal 407 in Form einer Spannung an dem Relaisschaltkontakt ein. Entsprechend ändert sich der Gesamtwiderstand an dem Signalausgang der Impedanzschaltung, da der elektrisch leitende Relaisschaltkontakt mit dem parallel zu dem Relaisschaltkontakt angeordneten Kondensator im Vergleich zu dem elektrisch nichtleitenden Relaisschaltkontakt eine geringere Impedanz aufweist. Die Änderung des Gesamtwiderstands kann eine Änderung eines primärseitigen Signals an dem Signaleingang respektive dem Signalgenerator erzeugen, welche beispielsweise eine geänderte Stromamplitude sein kann, die mittels des Stromsensors erfassbar ist.

Die Steuerung ist ausgebildet die Stromänderung zu dem Zeitpunkt t2 zu erfassen und entsprechend ein Schalten es Relaisschaltkontakts zu dem Zeitpunkt t2 zu erfassen. Die Steuerung kann ferner ausgebildet sein, den Signalgenerator und entsprechend das Anregungssignal 405 zu dem Zeitpunkt t5 abzuschalten. Alternativ kann die Steuerung ausgebildet sein, das Anregungssignal 405 kontinuierlich zu erzeugen, um eine kontinuierliche Beaufschlagung des Relaisschaltkontakts mit dem Schaltüberwachungssignal 407 zu realisieren. Insbesondere kann in dem Zeitintervall Δ2 zwischen dem Zeitpunkt t5 und dem Zeitpunkt t7 das Anregungssignal 405 erzeugt sein.

In einer Ausführungsform ist die Steuerung ausgebildet, den Signalgenerator zyklisch anzusteuern, um in wiederkehrenden Intervallen das Anregungssignal 405 zu generieren und den Schaltzustand des Relaisschaltkontakts zu überwachen. Entsprechend kann die Steuerung ausgebildet sein, anhand eines absoluten Amplitudenwerts und/oder effektiven Amplitudenwerts einer Amplitude des Anregungssignals 405 zu erfassen, ob sich der Relaisschaltkontakt in dem ersten Schaltzustand oder in dem zweiten Schaltzustand befindet. Demnach kann mit einer periodischen Überprüfung des Relaisschaltkontakts mittels der Schaltüberwachungsvorrichtung beispielsweise sichergestellt werden, dass der Relaisschaltkontakt elektrisch leitend ist.

Mit dem Schalten des Relaisschaltkontakts in den zweiten Schaltzustand erzeugt die Steuerung an dem Steuerausgang ein Statussignal 409, um eine Rückmeldung über das Schalten des Relaisschaltkontakts zu generieren.

Ein Ausschalten des Relais durch einen Wechsel des Relaisschaltkontakts von dem zweiten Schaltzustand in den ersten Schaltzustand kann durch ein Abschalten des Relaisansteuersignals zu dem Zeitpunkt t7 realisiert sein. Ab dem Zeitpunkt t7 kann der Signalgenerator eingeschaltet sein, um das Anregungssignal 405 zu generieren und entsprechend den Relaisschaltkontakt mit dem Schaltüberwachungssignal 407 zu beaufschlagen. Mit dem Zeitpunkt t10 kann der Signalgenerator abgeschaltet sein.

Der Relaisschaltkontakt beginnt ab dem Zeitpunkt t8 zu öffnen und entsprechend die elektrische Verbindung über den Relaisschaltkontakt zu trennen. Ab dem Zeitpunkt t9 ist der Schaltkontakt vollständig geöffnet und elektrisch nicht mehr leitfähig. Ein Lichtbogen zwischen den öffnenden Kontaktstellen des Relaisschaltkontakts kann ab dem Zeitpunkt t9 erloschen sein.

Ein Zeitintervall zwischen den Zeitpunkten t2 und t3, in welchem der Relaisschaltkontakt prellt und ein weiteres Zeitintervall zwischen den Zeitpunkten t8 und t9, in welchem ein Lichtbogen an dem Relaisschaltkontakt gebildet ist, können für jeden Schaltvorgang variieren. Der Signalgenerator verbleibt über das jeweilige Zeitintervall hinaus angeschaltet, um die Zeitabweichung des jeweiligen Zeitintervalls und/oder den vollständigen Anschaltrespektive Abschaltvorgang des Relaisschaltkontakts erfassen zu können.

Die Steuerung kann ferner ausgebildet sein, auf Basis des Signalverlaufs des Anregungssignals 405 und des Signalverlaufs des Schaltüberwachungssignals 407 eine Anzahl von Prellungen und/oder eine Prelldauer zu ermitteln. Weiterhin kann die Steuerung ausgebildet sein, die ermittelte Prelldauer und/oder die ermittelte Anzahl von Prellungen mit einem jeweiligen Grenzwert zu vergleichen.

Die Steuerung kann ferner ausgebildet sein, den Spulenstrom 403 zu erfassen und auf Grundlage des zeitlichen Amplitudenverlaufs des Spulenstroms 403 bei einem Beaufschlagen der elektromagnetischen Relaisspule mit dem Schaltsignal einen Ankeraufschlagzeitpunkt t6 zu bestimmen. Der Ankeraufschlagzeitpunkt t6, kann dadurch definiert sein, dass das Magnetsystem einen Anker des Relais maximal ausgelenkt hat und entsprechend ein Arbeitsluftspalt zwischen einem Joch des Relais und dem Anker vollständig überwunden wurde. Ferner kann mit dem Ankeraufschlagzeitpunkt t6 ein mechanischer Kontakt zwischen Schaltflächen des Relaisschaltkontakt mit einer maximal möglichen Druckkraft beaufschlagt sein. Die Steuerung kann ausgebildet sein, den Zeitpunkt t2, ab welchem der Relaisschaltkontakt elektrisch leitet und den Ankeraufschlagzeitpunkt t6 zu bestimmen.

Ferner kann die Steuerung ausgebildet sein ein Zeitintervall Δ1 zwischen dem Zeitpunkt t2 und dem Zeitpunkt t6 zu bestimmen. Mit den Signalverläufen des Anregungssignals 405, des Schaltüberwachungssignals 407 und/oder des Spulenstroms 403 in dem Zeitintervall Δ1 kann die Steuerung ausgebildet sein, typische Relaiskenngrößen zu bestimmen. Ferner kann die Steuerung ausgebildet sein die typischen Relaiskenngrößen kontinuierlich oder in periodischen Intervallen zu bestimmen, um aus einem zeitlichen Verlauf der Relaiskenngrößen eine Abnutzung, eine Ausfallwahrscheinlichkeit und/oder einen Wartungs- respektive Austauschzeitpunkt des Relais zu bestimmen. Die Steuerung kann ferner ausgebildet sein, ein Schaltspiel des Relais zu erfassen.

Weiterhin kann die Steuerung ausgebildet sein, ab dem Zeitpunkt t4 das Statussignal 409 aktiv zu schalten und entsprechend eine Signalamplitude des Statussignals 409 zu erhöhen. Ferner kann die Steuerung ausgebildet sein, ab dem Zeitpunkt t8 das Statussignal 409 inaktiv zu schalten und entsprechend eine Signalamplitude des Statussignals 409 zu verringern.

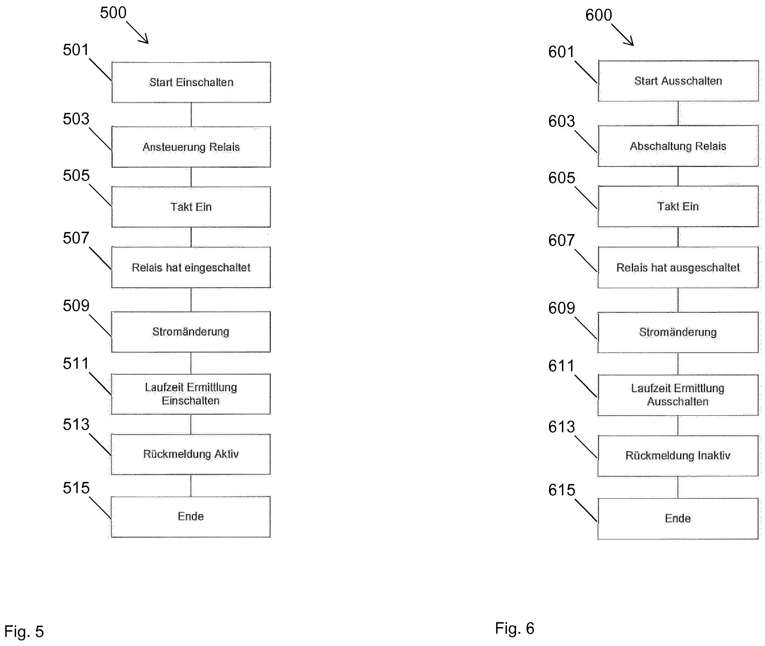

Fig. 5 zeigt eine Ereignissequenz 500 eines Einschaltens eines Relais mittels der Schaltüberwachungsvorrichtung in einer Ausführungsform. Die Ereignissequenz 500 beginnt mit dem Start des Einschaltens 501, welcher dadurch gekennzeichnet ist, dass an dem Ansteuereingang der Steuerung ein Relaisansteuersignal anliegt. Darauffolgend beaufschlagt die Steuerung das Magnetsystem des Relais mit dem Ansteuersignal, sodass eine Ansteuerung des Relais 503 erfolgt. Anschließend wird der Signalgenerator eingeschaltet, um das Taktsignal zu generieren, gekennzeichnet durch Takt Ein 505. Nach Ablauf der Anschaltverzögerung des Relais schließt der Relaisschaltkontakt und das Relais hat eingeschaltet 507.

Mit dem Schließen des Relaisschaltkontaktes ändert sich der Stromfluss durch den Relaisschaltkontakt und entsprechend durch den Signalausgang der Impedanzschaltung, sodass eingangsseitig eine Stromänderung 509 erfolgt. Mittels Einschalten der Laufzeitermittlung 511 kann ein Einschaltzeitpunkt des Relaisschaltkontaktes ermittelt und von der Steuerung erfasst werden.

Anschließend schaltet die Steuerung die Rückmeldung aktiv 513, indem an dem Steuerausgang das Statussignal 409 aktiv geschaltet wird. Das Einschalten des Relais ist damit abgeschlossen und die Ereignissequenz 500 endet 515.

Fig. 6 zeigt eine Ereignissequenz 600 eines Ausschaltens eines Relais mittels der Schaltüberwachungsvorrichtung in einer Ausführungsform. Die Ereignissequenz 500 beginnt mit dem Start des Ausschaltens 601, welcher dadurch gekennzeichnet ist, dass an dem Ansteuereingang der Steuerung ein Relaisansteuersignal nicht mehr anliegt. Entsprechend liegt an dem Magnetsystem des Relais das Ansteuersignal nicht an. Anschließend wird der Signalgenerator eingeschaltet, um das Taktsignal zu generieren, gekennzeichnet durch Takt Ein 605. Nach Ablauf der Abschaltverzögerung des Relais öffnet der Relaisschaltkontakt und das Relais hat ausgeschaltet 507.

Mit dem Öffnen des Relaisschaltkontaktes ändert sich der Stromfluss durch den Relaisschaltkontakt und entsprechend durch den Signalausgang der Impedanzschaltung, sodass eingangsseitig eine Stromänderung 609 erfolgt. Mittels Abschalten der Laufzeitermittlung 611 kann ein Abschaltzeitpunkt von der Steuerung erfasst werden, um eine Laufzeit des Relais anhand der Differenz zwischen dem Einschaltzeitpunkt und dem Abschaltzeitpunkt zu ermitteln.

Anschließend schaltet die Steuerung die Rückmeldung inaktiv 613, indem an dem Steuerausgang das Statussignal 409 inaktiv geschaltet wird. Das Abschalten des Relais ist damit abgeschlossen und die Ereignissequenz 600 endet 615.

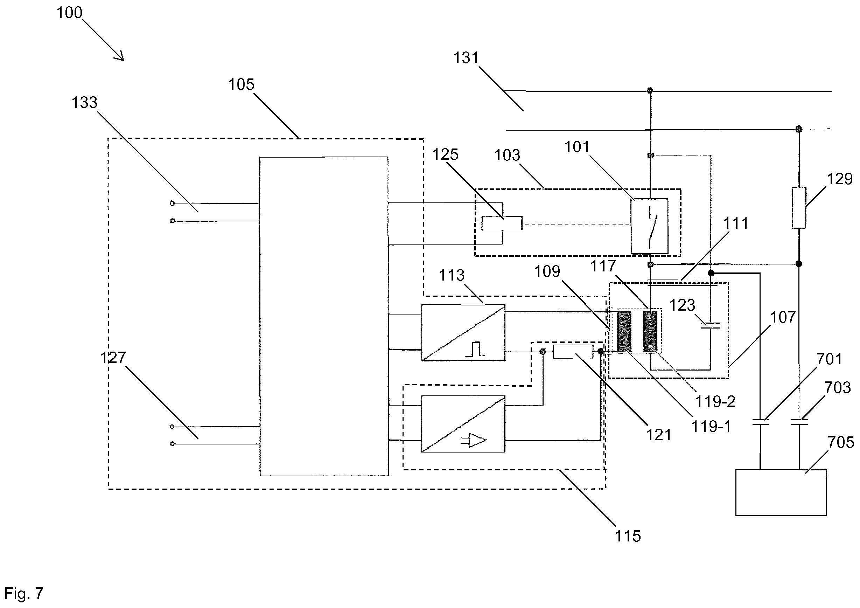

Fig. 7 zeigt eine schematische Darstellung einer Schaltüberwachungsvorrichtung 100 zur Überwachung eines Schaltvorgangs eines Relaisschaltkontakts 101 eines Relais 103. Die Schaltüberwachungsvorrichtung 100 umfasst ferner zwei Koppelungskondensatoren 701, 703 und eine Signalüberwachungsschaltung 705. Die Kondensatoren 701, 703 sind eingangsseitig an den Signalausgang 111 angeschaltet und ausgangsseitig an die Signalüberwachungsschaltung 705 angeschaltet. Weiterhin sind die Koppelungskondensatoren 701, 703 ausgebildet, ein an dem Relaisschaltkontakt anliegendes Signal, insbesondere das Schaltüberwachungssignal, kapazitiv an die Signalüberwachungsschaltung 705 zu koppeln.

Dadurch wird der Vorteil erreicht, dass die Impedanzschaltung 107 das Schaltüberwachungssignal induktiv an den Relaisschaltkontakt 101 ankoppeln kann und mittels der Koppelungskondensatoren 701, 703 eine Änderung des Schaltüberwachungssignals kapazitiv erfasst und der Signalüberwachungsschaltung 705 bereitgestellt werden kann. Die Signalüberwachungsschaltung 705 kann ausgebildet sein, eine Änderung des Schaltüberwachungssignals zu erfassen und das Statussignal bereitzustellen. Ferner können die Koppelungskondensatoren 701, 703 und/oder die Signalüberwachungsschaltung 705 Bestandteil der Steuerung 105 sein und/oder in diese integriert sein.

### Bezugszeichenliste

- 100: Schaltüberwachungsvorrichtung
- 101: Relaisschaltkontakt
- 103: Relais
- 105: Steuerung
- 107: Impedanzschaltung
- 109: Signaleingang
- 111: Signalausgang
- 113: Signalgenerator
- 115: Messschaltung
- 117: Transformator
- 119-1: Primärseitige Spule
- 119-2: Sekundärseitige Spule
- 121: Stromsensor
- 123: Kondensator
- 125: Magnetsystem
- 127: Steuerausgang
- 129: Elektrische Last
- 131: Spannungsquelle
- 133: Ansteuereingang

- 201-1: Erster Eingangsanschluss
- 201-2: Zweiter Eingangsanschluss
- 203-1: Erster Ausgangsanschluss
- 203-2: Zweiter Ausgangsanschluss
- 205-1: Erster Kondensator
- 205-2: Zweiter Kondensator
- 207: Induktivität

- 301-1: Erstes Dämpfungselement
- 301-2: Zweites Dämpfungselement
- 303-1: Induktivität
- 303-2: Induktivität
- 400: Signalformen
- 401: Spulenspannung
- 403: Spulenstrom
- 405: Anregungssignal
- 407: Schaltüberwachungssignal
- 409: Statussignal

- t1: Zeitpunkt
- t2: Zeitpunkt
- t3: Zeitpunkt
- t4: Zeitpunkt
- t5: Zeitpunkt
- t6: Zeitpunkt
- t7: Zeitpunkt
- t8: Zeitpunkt
- t9: Zeitpunkt
- t10: Zeitpunkt

- Δ1: Zeitintervall
- Δ2: Zeitintervall

- 500: Ereignissequenz
- 501: Start Einschalten
- 503: Ansteuerung Relais
- 505: Takt Ein
- 507: Relais hat eingeschaltet
- 509: Stromänderung
- 511: Laufzeitermittlung Einschalten
- 513: Rückmeldung Aktiv
- 515: Ende Einschalten

- 600: Ereignissequenz
- 601: Start Ausschalten
- 603: Abschaltung Relais
- 605: Takt Ein
- 607: Relais hat ausgeschaltet
- 609: Stromänderung
- 611: Laufzeitermittlung Ausschalten
- 613: Rückmeldung Inaktiv
- 615: Ende Ausschalten

- 701: Koppelungskondensator
- 703: Koppelungskondensator
- 705: Signalüberwachungsschaltung

## Patentansprüche

1. Schaltüberwachungsvorrichtung (100) zur Überwachung eines Schaltvorgangs eines Relaisschaltkontakts (101) eines Relais (103), wobei die Schaltüberwachungsvorrichtung (100) die folgenden Merkmale aufweist:
einen Ansteueranschluss (102), welcher ausgebildet ist, ein Ansteuersignal zum Schalten des Relaisschaltkontakts (101) an den Relaisschaltkontakt (101) anzulegen,
eine Steuerung (105), welche ausgebildet ist, ein Anregungssignal zu erzeugen, wobei die Steuerung (105) einen Signalgenerator (113) zum Erzeugen des Anregungssignals aufweist, und
eine Impedanzschaltung (107) mit einem Signaleingang (109) und einem Signalausgang (111), wobei die Steuerung (105) ausgebildet ist, das Anregungssignal an den Signaleingang (109) anzulegen, wobei die Impedanzschaltung (107) ausgebildet ist, das Anregungssignal in ein Schaltüberwachungssignal zu überführen und das Schaltüberwachungssignal an dem Signalausgang (111) zum Beaufschlagen des Relaisschaltkontaktes (101) auszugeben, wobei die Impedanzschaltung (107) einen Transformator (117) mit einer primärseitigen Spule (119-1) und einer sekundärseitigen Spule (119-2) umfasst, und wobei die sekundärseitige Spule (119-2) parallel zu dem Relaisschaltkontakt (101) geschaltet ist, und wobei die primärseitige Spule (119) mit dem Signalgenerator (113) verbunden ist,
**dadurch gekennzeichnet, dass**
die Impedanzschaltung (107) einen Kondensator (123) aufweist, welcher in Reihe zu der sekundärseitigen Spule (119-2) angeordnet ist; und wobei
die Steuerung (105) ferner ausgebildet ist, eine Änderung eines an der Impedanzschaltung (107) anliegenden Signals zu überwachen und bei Vorliegen der Änderung des Signals einen Schaltvorgang des Relaisschaltkontakts (101) festzustellen.

2. Schaltüberwachungsvorrichtung (100) nach Anspruch 1, wobei das Signal das Anregungssignal und/oder das Schaltüberwachungssignal umfasst.

3. Schaltüberwachungsvorrichtung (100) nach einem der vorstehenden Ansprüche, wobei die Steuerung (105) eine Messschaltung (115) zum Erfassen der Änderung des Anregungssignals aufweist.

4. Schaltüberwachungsvorrichtung (100) nach einem der vorstehenden Ansprüche, wobei die Messschaltung (115) einen Stromsensor (121) aufweist, welcher zwischen den Signalgenerator (113) und die Impedanzschaltung (107) geschaltet ist, wobei der Stromsensor (121) ausgebildet ist, einen Stromfluss zwischen dem Signalgenerator (113) und der Impedanzschaltung (107) zu erfassen und der Steuerung (105) als einen Strommesswert bereitzustellen, und wobei die Steuerung (105) ausgebildet ist, auf Basis des Strommesswertes eine Änderung des Stromflusses zwischen dem Signalgenerator (113) und der Impedanzschaltung (107) zu erfassen.

5. Schaltüberwachungsvorrichtung (100) nach einem der vorstehenden Ansprüche, wobei die Impedanzschaltung (107) ausgebildet ist, den Relaisschaltkontakt (101) von dem Signalgenerator (113) und/oder der Steuerung (105) galvanisch zu trennen.

6. Schaltüberwachungsvorrichtung (100) nach einem der vorstehenden Ansprüche, wobei der Kondensator (123) ausgebildet ist, einen Blindwiderstand für Wechselspannungssignale zu bilden, welche an dem Relaisschaltkontakt (101) anliegen.

7. Schaltüberwachungsvorrichtung (100) nach einem der vorstehenden Ansprüche, wobei die Steuerung (105) an den Ansteueranschluss (102) anschließbar und ausgebildet ist, ein Ansteuersignal zum Schalten des Relaisschaltkontakts (101) zu erzeugen und/oder den Ansteueranschluss (102) mit dem Ansteuersignal zu beaufschlagen.

8. Schaltüberwachungsvorrichtung (100) nach Anspruch 7, wobei die Steuerung (105) eine Schaltsteuerung umfasst, welche ausgebildet ist, das Ansteuersignal zum Schalten des Relaisschaltkontakts (101) zu erzeugen und ein Magnetsystem (125) des Relais (103) mit Ansteuersignal zu beaufschlagen, um den Relaisschaltkontakt (101) zu schalten.

9. Schaltüberwachungsvorrichtung (100) nach Anspruch 7 oder 8, wobei die Steuerung (105) ausgebildet ist, den Signalgenerator (113) mit dem Ansteuersignal zu beaufschlagen, und wobei der Signalgenerator (113) ausgebildet ist, mit dem Schaltsignal das Anregungssignal zu erzeugen.

10. Schaltüberwachungsvorrichtung (100) nach einem der Ansprüche 7 bis 9, wobei der Signalgenerator (113) ausgebildet ist, das Anregungssignal in Form eines periodischen Taktsignals zu generieren, und wobei die Steuerung (105) ausgebildet ist, auf Basis der konstanten Periodendauer des Anregungssignals ein Zeitintervall zwischen dem Erzeugen des Anregungssignals und einer Änderung des Anregungssignals bei Änderung der Impedanz an dem Signalausgang (111) zu erfassen, um eine Schaltzeitverzögerung des Relaisschaltkontakts (101) zu erfassen.

11. Schaltüberwachungsvorrichtung (100) nach einem der vorstehenden Ansprüche, wobei die Steuerung (105) einen Steuerausgang (127) aufweist, und wobei die Steuerung (105) ausgebildet ist, an dem Steuerausgang (127) ein Statussignal bereitzustellen, welches nach einem Einschalten des Relaisschaltkontakts (101) aktiv ist und nach einem Ausschalten des Relaisschaltkontakts (101) inaktiv ist.

12. Schaltüberwachungsvorrichtung (100) nach einem der vorstehenden Ansprüche, mit einem ersten Dämpfungselement (301-1), wobei der Signalausgang (111) einen ersten Ausgangsanschluss (203-1) aufweist, welchem das erste Dämpfungselement (301-1) nachgeschaltet ist, um hochfrequente Signale zu dämpfen, welche mittels der Impedanzschaltung (107) an den Relaisschaltkontakt (101) und/oder eine an den Relaisschaltkontakt (101) gekoppelte elektrische Last (129) und/oder Spannungsquelle (131) anliegen.

13. Schaltüberwachungsvorrichtung (100) nach einem der vorstehenden Ansprüche, mit einem zweiten Dämpfungselement (301-2), wobei der Signalausgang (111) einen zweiten Ausgangsanschluss (203-2) aufweist, welchem das zweite Dämpfungselement (301-2) nachgeschaltet ist, um hochfrequente Signale zu dämpfen, welche mittels der Impedanzschaltung (107) an dem Relaisschaltkontakt (101) und/oder an einer an den Relaisschaltkontakt (101) gekoppelten elektrische Last (129) und/oder Spannungsquelle (131) anliegen.

## Claims

1. Switching monitoring device (100) for monitoring a switching operation of a relay switching contact (101) of a relay (103), the switching monitoring device (100) comprising the following features:
a control terminal (102), which is adapted to apply a control signal for switching the relay switching contact (101) to the relay switching contact (101),
a controller (105), which is adapted to generate an excitation signal, wherein the controller (105) comprises a signal generator (113) for generating the excitation signal, and
an impedance circuit (107) comprising a signal input (109) and a signal output (111), wherein the controller (105) is adapted to apply the excitation signal to the signal input (109), wherein the impedance circuit (107) is adapted to convert the excitation signal into a switching monitoring signal and to output the switching monitoring signal at the signal output (111) for applying it to the relay switching contact (101);
wherein the impedance circuit (107) comprises a transformer (117) with a primary-side coil (119-1) and a secondary-side coil (119-2), and wherein the secondary-side coil (119-2) is connected in parallel to the relay switching contact (101), and wherein the primary-side coil (119) is connected to the signal generator (113),
**characterized in that** the impedance circuit (107) comprises a capacitor (123), which is arranged in series with the secondary-side coil (119-2), wherein the controller (105) is further adapted to detect a change in a signal present at the impedance circuit (107) and, if the change in the signal is present, to detect a switching operation of the relay switching contact (101).

2. Switching monitoring device (100) according to claim 1, wherein the signal comprises the excitation signal and/or the switching monitoring signal.

3. Switching monitoring device (100) according to one of the preceding claims, wherein the controller (105) comprises a measuring circuit (115) for detecting the change in the excitation signal.

4. Switching monitoring device (100) according to one of the preceding claims, wherein the measuring circuit (115) comprises a current sensor (121), which is connected between the signal generator (113) and the impedance circuit (107), wherein the current sensor (121) is adapted to detect a current flow between the signal generator (113) and the impedance circuit (107) and to provide it to the controller (105) as a measured current value, and wherein the controller (105) is adapted to detect a change of the current flow between the signal generator (113) and the impedance circuit (107) on the basis of the measured current value.

5. Switching monitoring device (100) according to one of the preceding claims, wherein the impedance circuit (107) is adapted to galvanically separate the relay switching contact (101) from the signal generator (113) and/or the controller (105).

6. Switching monitoring device (100) according to one of the preceding claims, wherein the capacitor (123) is adapted to form a reactance for alternating voltage signals, which are applied to the relay switching contact (101).

7. Switching monitoring device (100) according to one of the preceding claims, wherein the controller (105) is connectable to the control terminal (102) and is adapted to generate a control signal for switching the relay switching contact (101) and/or to apply the control signal to the control terminal (102).

8. Switching monitoring device (100) according to claim 7, wherein the controller (105) comprises a switching controller, which is adapted to generate the control signal for switching the relay switching contact (101) and to apply the control signal to a magnet system (125) of the relay (103) to switch the relay switching contact (101).

9. Switching monitoring device (100) according to claim 7 or 8, wherein the controller (105) is adapted to apply the control signal to the signal generator (113), and wherein the signal generator (113) is adapted to generate the excitation signal using the switching signal.

10. Switching monitoring device (100) according to one of claims 7 to 9, wherein the signal generator (113) is adapted to generate the excitation signal in the form of a periodic clock signal, and wherein the controller (105) is adapted to detect a time interval, based on the constant period of the excitation signal, between the generation of the excitation signal and a change in the excitation signal upon a change of the impedance at the signal output (111), in order to detect a switching time delay of the relay switching contact (101).

11. Switching monitoring device (100) according to one of the preceding claims, wherein the controller (105) comprises a control output (127), and wherein the controller (105) is adapted to provide a status signal at the control output (127), which is active after the relay switching contact (101) is switched on and which is inactive after the relay switching contact (101) is switched off.

12. Switching monitoring device (100) according to one of the preceding claims, comprising a first damping element (301-1), wherein the signal output (111) comprises a first output terminal (203-1), which is upstream of the first damping element (301-1) in order to dampen high-frequency signals, which are applied by means of the impedance circuit (107) to the relay switching contact (101) and/or an electrical load (129) and/or a voltage source (131) coupled to the relay switching contact (101).

13. Switching monitoring device (100) according to one of the preceding claims, comprising a second damping element (301-2), wherein the signal output (111) comprises a second output terminal (203-2), which is upstream of the second damping element (301-2) in order to dampen high-frequency signals, which are applied by means of the impedance circuit (107) to the relay switching contact (101) and/or to an electrical load (129) and/or a voltage source (131) coupled to the relay switching contact (101).

## Revendications

1. Dispositif de surveillance de commutation (100) pour surveiller une opération de commutation d'un contact de commutation de relais (101) d'un relais (103), le dispositif de surveillance de commutation (100) présentant les caractéristiques suivantes :
une borne de commande (102), qui est adaptée pour appliquer un signal de commande pour commuter le contact de commutation de relais (101) au contact de commutation de relais (101),
un contrôleur (105), qui est adapté pour générer un signal d'excitation, le contrôleur (105) comprenant un générateur de signal (113) pour générer le signal d'excitation, et
un circuit d'impédance (107) ayant une entrée de signal (109) et une sortie de signal (111), dans lequel le contrôleur (105) est adapté pour appliquer le signal d'excitation à l'entrée de signal (109), dans lequel le circuit d'impédance (107) est adapté pour convertir le signal d'excitation en un signal de surveillance de commutation et pour délivrer le signal de surveillance de commutation à la sortie de signal (111) pour appliquer le contact de commutation de relais (101) ;
dans lequel le circuit d'impédance (107) comprend un transformateur (117) avec une bobine côté primaire (119-1) et une bobine côté secondaire (119-2), et dans lequel la bobine côté secondaire (119-2) est connectée en parallèle au contact de commutation du relais (101), et dans lequel la bobine côté primaire (119) est connectée au générateur de signal (113),
**caractérisé en ce que** le circuit d'impédance (107) comporte un condensateur (123), qui est disposé en série avec la bobine côté secondaire (119-2), le contrôleur (105) étant en outre adapté pour détecter un changement dans un signal présent au niveau du circuit d'impédance (107) et, si le changement dans le signal est présent, pour détecter une opération de commutation du contact de commutation de relais (101).

2. Dispositif de surveillance de commutation (100) selon la revendication 1, dans lequel le signal comprend le signal d'excitation et/ou le signal de surveillance de commutation.

3. Dispositif de surveillance de commutation (100) selon l'une des revendications précédentes, dans lequel le contrôleur (105) comprend un circuit de mesure (115) pour détecter le changement du signal d'excitation.

4. Dispositif de surveillance de commutation (100) selon l'une des revendications précédentes, dans lequel le circuit de mesure (115) comporte un capteur de courant (121) qui est connecté entre le générateur de signal (113) et le circuit d'impédance (107), le capteur de courant (121) étant adapté pour détecter un flux de courant entre le générateur de signal (113) et le circuit d'impédance (107) et pour le fournir au contrôleur (105) en tant que valeur de courant mesurée, et le contrôleur (105) étant adapté pour détecter une modification du flux de courant entre le générateur de signal (113) et le circuit d'impédance (107) sur la base de la valeur de courant mesurée.

5. Dispositif de surveillance de commutation (100) selon l'une des revendications précédentes, dans lequel le circuit d'impédance (107) est adapté pour séparer galvaniquement le contact de commutation de relais (101) du générateur de signaux (113) et/ou du contrôleur (105).

6. Dispositif de surveillance de commutation (100) selon l'une des revendications précédentes, dans lequel le condensateur (123) est adapté pour former une réactance pour des signaux de tension alternative, qui sont appliqués au contact de commutation de relais (101).

7. Dispositif de surveillance de commutation (100) selon l'une des revendications précédentes, dans lequel le contrôleur (105) peut être connecté à la borne de commande (102) et est adapté pour générer un signal de commande pour commuter le contact de commutation de relais (101) et/ou pour appliquer le signal de commande à la borne de commande (102).

8. Dispositif de surveillance de commutation (100) selon la revendication 7, dans lequel le contrôleur (105) comprend un contrôleur de commutation, qui est adapté pour générer le signal de commande pour commuter le contact de commutation de relais (101) et pour appliquer le signal de commande à un système magnétique (125) du relais (103) pour commuter le contact de commutation de relais (101).

9. Dispositif de surveillance de commutation (100) selon la revendication 7 ou 8, dans lequel le contrôleur (105) est adapté pour appliquer le signal de commande au générateur de signal (113), et dans lequel le générateur de signal (113) est adapté pour générer le signal d'excitation avec le signal de commutation.

10. Dispositif de surveillance de commutation (100) selon l'une des revendications 7 à 9, dans lequel le générateur de signal (113) est adapté pour générer le signal d'excitation sous la forme d'un signal d'horloge périodique, et dans lequel le contrôleur (105) est adapté pour détecter un intervalle de temps entre la génération du signal d'excitation et une modification du signal d'excitation lorsque l' impédance à la sortie de signal (111) change, sur la base de la période constante du signal d'excitation, afin de détecter un retard de commutation du contact de commutation de relais (101).

11. Dispositif de surveillance de commutation (100) selon l'une des revendications précédentes, dans lequel le contrôleur (105) comporte une sortie de commande (127), et dans lequel le contrôleur (105) est adapté pour fournir un signal d'état à la sortie de commande (127), qui est actif après la mise sous tension du contact de commutation de relais (101) et est inactif après la mise hors tension du contact de commutation de relais (101).

12. Dispositif de surveillance de commutation (100) selon l'une des revendications précédentes, comprenant un premier élément d'amortissement (301-1), la sortie de signal (111) comportant une première connexion de sortie (203-1) qui est suivie par le premier élément d'amortissement (301-1) afin d'amortir les signaux haute fréquence qui sont appliqués au moyen du circuit d'impédance (107) au contact de commutation de relais (101) et/ou à une charge électrique (129) et/ou à une source de tension (131) couplée au contact de commutation de relais (101).

13. Dispositif de surveillance de commutation (100) selon l'une des revendications précédentes, comprenant un deuxième élément d'amortissement (301-2), la sortie de signal (111) comportant une deuxième connexion de sortie (203-2) qui est suivie par le deuxième élément d'amortissement (301-2) afin d'amortir les signaux haute fréquence qui sont appliqués au moyen du circuit d'impédance (107) au contact de commutation de relais (101) et/ou à une charge électrique (129) et/ou à une source de tension (131) couplée au contact de commutation de relais (101).
